# EUROPEAN PATENT APPLICATION

(11) **EP 4 650 861 A1**
(43) Date of publication of application: **19.11.2025**
(21) Application number: 24305779.1
(22) Date of filing: 17.05.2024
(51) Int. Cl.: G02F 1/01, G02B 6/12, G02B 6/122, H01S 5/10, G02B 6/136, H01S 5/024

(54) **SEMICONDUCTOR DEVICE AND SEMICONDUCTOR DEVICE FABRICATION METHOD**

(71) Applicant: Nokia Solutions and Networks Oy, 02610 Espoo (FI)
(72) Inventor: RAMIREZ, Joan Manel, 91440 Bures-sur-Yvette (FR); CALO, Cosimo, 91400 Orsay (FR); NEEL, Delphine, 91140 Villebon-sur-Yvette (FR); VAISSIERE, Nicolas, 91120 Palaiseau (FR)
(74) Representative: Novagraaf Technologies

(57) **Abstract**

There is provided a waveguide structure and a method of manufacturing a waveguide structure. The waveguide structure comprises a first waveguide 102 arranged on a substrate 104 and comprises a non-tapered section 150 and a tapered section 152. The waveguide structure comprises a second waveguide 110. The second waveguide is under the first waveguide in the substrate and arranged for transition of an optical signal from/to the first waveguide to/from the second waveguide. The non-tapered section and the tapered section of the first waveguide are at least partially buried in a thermally conductive cladding 112. A dielectric layer 114 is arranged between the tapered section and the thermally conductive cladding and has a lower refractive index than the second waveguide.

## Description

### Field

Examples of the present disclosure relates to semiconductor devices and semiconductor device fabrication methods.

### Background

III-V semiconductor technology finds useful application in optoelectronics. However, there are challenges combining such technology with other platforms (for example, silicon-based platforms) in order to exploit the beneficial characteristics of both III-V technology and such other platforms.

An objective of the present disclosure is to address such challenges, amongst others.

### Summary

In a first exemplary aspect, there is provided a waveguide structure comprising:
a first waveguide arranged on a substrate, wherein the first waveguide is a semi-insulating buried heterostructure, SIBH, comprising a non-tapered section and a tapered section, the tapered section connected to an end of the non-tapered section, and the non-tapered section and the tapered section being a III-V semiconductor material, the non-tapered section comprising two first sidewalls projecting from the substrate, wherein the two first sidewalls are substantially parallel to one another, the tapered section comprising two second sidewalls projecting from the substrate, wherein the two second sidewalls are respectively connected to the first sidewalls and extend from the first sidewalls at an end of the non-tapered section toward one another to define a tapered shape;
a second waveguide, wherein the second waveguide is under the first waveguide in the substrate and arranged for transition of an optical signal from/to the first waveguide to/from the second waveguide;
a thermally conductive cladding, wherein the non-tapered section and the tapered section of the first waveguide are at least partially buried in the thermally conductive cladding; and
a dielectric layer between the second sidewalls of the tapered section and the thermally conductive cladding to separate the tapered section from the thermally conductive cladding, wherein the dielectric layer has a lower refractive index than the second waveguide.

Optionally, the dielectric layer is a polymer layer.

Optionally, the second sidewalls are separated from the dielectric layer by a second dielectric layer that is configured to prevent III-V crystalline growth thereon.

Optionally, the tapered section is a first tapered section connected to a first end of the non-tapered section, and the first waveguide further comprises a second tapered section connected to a second end of the non-tapered section, wherein the second end of the non-tapered section is an opposite end to the first end, and wherein the second tapered section tapers in a direction opposite to a direction in which the first tapered section tapers.

Optionally, the first waveguide is arranged on an InP-based layer, and the InP-based layer is arranged on the substrate.

Optionally, an active region is arranged between the first waveguide and the InP-based layer.

Optionally, the III-V semiconductor material of the first waveguide is p-type doped InP.

Optionally, the thermally conductive cladding comprises InP:Fe.

Optionally, the substrate is a silicon-on-insulator, SOI, substrate, and the SOI substrate comprises one or more photonic components arranged therein or thereon.

In a second exemplary aspect, there is provided a semiconductor optical amplifier comprising the waveguide structure of the first exemplary aspect.

In a third exemplary aspect, there is provided laser comprising the waveguide structure of the first exemplary aspect.

In a fourth exemplary aspect, there is provided a photodiode comprising the waveguide structure of the first exemplary aspect.

In a fifth exemplary aspect, there is provided a modulator comprising the waveguide structure of the first exemplary aspect.

In a sixth exemplary aspect, there is provided a method of fabricating a waveguide structure, the method comprising:
providing a first waveguide, wherein the first waveguide is a semi-insulating buried heterostructure, SIBH, comprising a non-tapered section and a tapered section, the tapered section connected to an end of the non-tapered section, and the non-tapered section and the tapered section being a III-V semiconductor material, the non-tapered section comprising two first sidewalls, wherein the two first sidewalls are substantially parallel to one another, and the tapered section comprising two second sidewalls, wherein the two second sidewalls are respectively connected to the first sidewalls and extend from the first sidewalls at an end of the non-tapered section toward one another to define a tapered shape;
depositing a dielectric layer on the second sidewalls of the tapered section;
at least partially burying the non-tapered section and the tapered section in a thermally conductive cladding, wherein the dielectric layer is arranged between the second sidewalls and the thermally conductive cladding to separate the tapered section from the thermally conductive cladding; and
arranging the first waveguide on a second waveguide so that an optical signal is transitionable from/to the first waveguide to/from the second waveguide, wherein the dielectric layer has a lower refractive index than the second waveguide.

Optionally, the method further comprises, before depositing the dielectric layer, depositing a second dielectric layer on the second sidewalls of the tapered section, wherein the second dielectric layer is then arranged between the second sidewalls and the dielectric layer, and the second dielectric layer is configured to prevent III-V crystalline growth thereon.

### Brief Description of Drawings

Examples of the disclosure are now described, with reference to the drawings, in which:
FIG. 1A is a schematic diagram of a top-down view of a waveguide structure;
FIG. 1B is a cross-sectional diagram of the waveguide structure of FIG. 1A along the line X-X';
FIG. 1C is a cross-sectional diagram of the waveguide structure of FIG. 1A along the line Y-Y';
FIG. 1D is a cross-sectional diagram of the waveguide structure of FIG. 1A along the line Z-Z';
FIG. 2A is a cross-sectional schematic view of a waveguide structure in a first fabrication step;
FIG. 2B is a top-down schematic view of the waveguide structure in the first fabrication step;
FIG. 3A is a cross-sectional schematic view of the waveguide structure in a second fabrication step;
FIG. 3B is a top-down schematic view of the waveguide structure in the second fabrication step;
FIG. 4A is a cross-sectional schematic view of the non-tapered section of the waveguide structure in a third fabrication step;
FIG. 4B is a cross-sectional schematic view of the tapered section of the waveguide structure in the third fabrication step;
FIG. 4C is a top-down schematic view of the waveguide structure in the third fabrication step;
FIG. 5A is a cross-sectional schematic view of the non-tapered section of the waveguide structure in a fourth fabrication step;
FIG. 5B is a cross-sectional schematic view of the tapered section of the waveguide structure in the fourth fabrication step;
FIG. 5C is a top-down schematic view of the waveguide structure in the fourth fabrication step;
FIG. 6A is a cross-sectional schematic view of the non-tapered section of the waveguide structure in a fifth fabrication step;
FIG. 6B is a cross-sectional schematic view of the tapered section of the waveguide structure in the fifth fabrication step;
FIG. 6C is a top-down schematic view of the waveguide structure in the fifth fabrication step;
FIG. 7A is a cross-sectional schematic view of the non-tapered section of the waveguide structure in a sixth fabrication step;
FIG. 7B is a cross-sectional schematic view of the tapered section of the waveguide structure in the sixth fabrication step;
FIG. 7C is a top-down schematic view of the waveguide structure in the sixth fabrication step;
FIG. 8A is a cross-sectional schematic view of the non-tapered section of the waveguide structure in a seventh fabrication step;
FIG. 8B is a cross-sectional schematic view of the tapered section of the waveguide structure in the seventh fabrication step;
FIG. 8C is a top-down schematic view of the waveguide structure in the seventh fabrication step;
FIG. 9A is a cross-sectional schematic view of the non-tapered section of the waveguide structure in an eighth fabrication step;
FIG. 9B is a cross-sectional schematic view of the tapered section of the waveguide structure in the eighth fabrication step;
FIG. 9C is a top-down schematic view of the waveguide structure in the eighth fabrication step;
FIG. 10A is a cross-sectional schematic view of the non-tapered section of the waveguide structure in a ninth fabrication step;
FIG. 10B is a cross-sectional schematic view of the tapered section of the waveguide structure in the ninth fabrication step;
FIG. 10C is a top-down schematic view of the waveguide structure in the ninth fabrication step;
FIG. 11A is a cross-sectional schematic view of the non-tapered section of the waveguide structure in a tenth fabrication step;
FIG. 11B is a cross-sectional schematic view of the tapered section of the waveguide structure in the tenth fabrication step;
FIG. 11C is a top-down schematic view of the waveguide structure in the tenth fabrication step;
FIG. 12A is a cross-sectional schematic view of the non-tapered section of the waveguide structure in an eleventh fabrication step;
FIG. 12B is a cross-sectional schematic view of the tapered section of the waveguide structure in the eleventh fabrication step;
FIG. 12C is a top-down schematic view of the waveguide structure in the eleventh fabrication step;
FIG. 13A is a cross-sectional schematic view of the non-tapered section of the waveguide structure in a twelfth fabrication step;
FIG. 13B is a cross-sectional schematic view of the tapered section of the waveguide structure in the twelfth fabrication step;
FIG. 13C is a top-down schematic view of the waveguide structure in the twelfth fabrication step;
FIG. 14A is a cross-sectional schematic view of the non-tapered section of the waveguide structure in a thirteenth fabrication step;
FIG. 14B is a cross-sectional schematic view of the tapered section of the waveguide structure in the thirteenth fabrication step;
FIG. 14C is a top-down schematic view of the waveguide structure in the thirteenth fabrication step;
FIG. 15 is a flow chart of an exemplary methodology, based upon the fabrication described with reference to FIGS. 2 to 14, but in generalised terms, for fabricating the waveguide structure of FIGS. 1A to 1D; and
FIGS. 16A, 16B and 16C depict simulations of a transition of an optical signal from the first waveguide into the second waveguide as the first waveguide narrows through the tapered section.

### Detailed Description

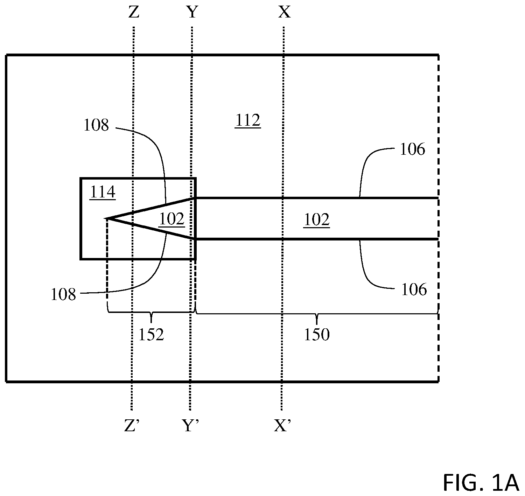

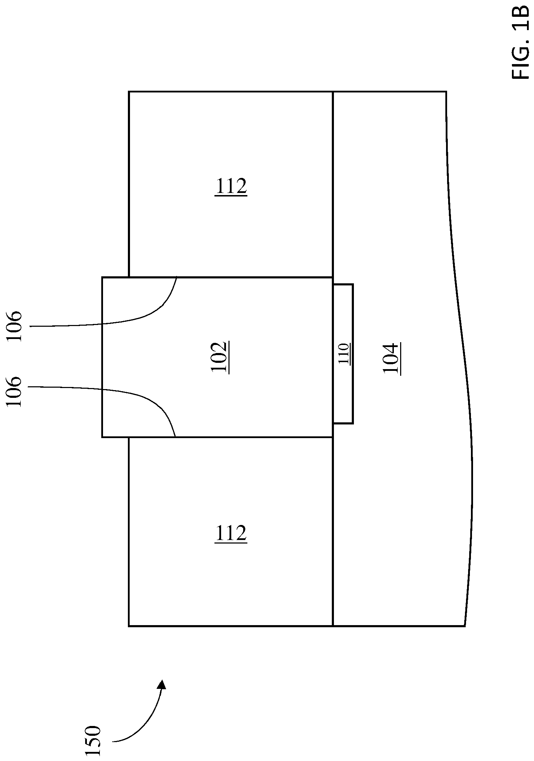

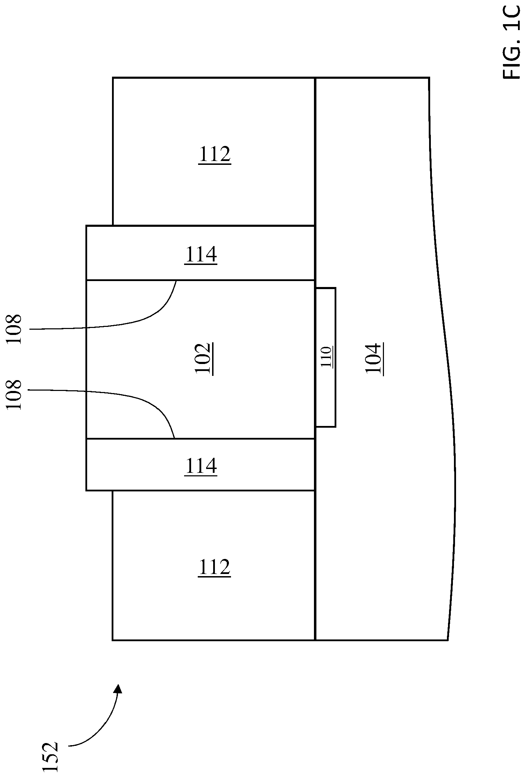

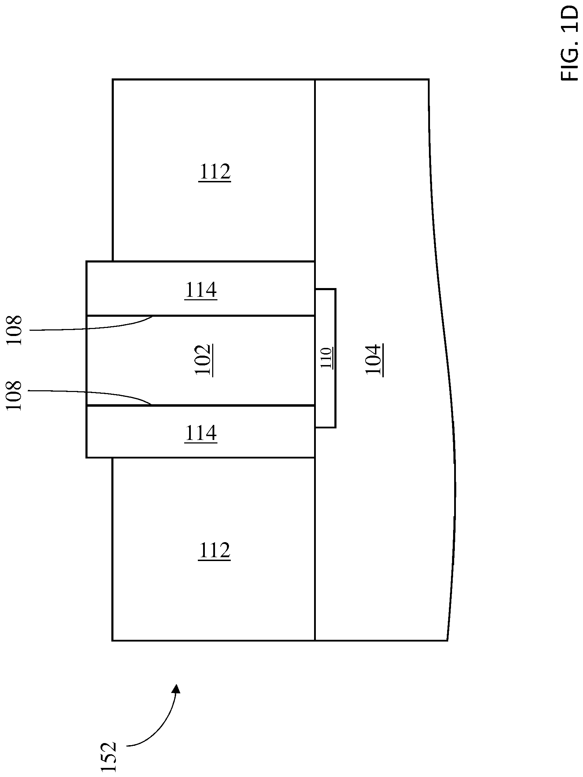

FIG. 1A is a schematic diagram of a top-down view of a waveguide structure. FIG. 1B is a cross-sectional diagram of the waveguide structure of FIG. 1A along the line X-X'. FIG. 1C is a cross-sectional diagram of the waveguide structure of FIG. 1A along the line Y-Y'. FIG. 1D is a cross-sectional diagram of the waveguide structure of FIG. 1A along the line Z-Z'.

The waveguide structure comprises a first waveguide 102 arranged on a substrate 104.

The first waveguide is a semi-insulating buried heterostructure (SIBH), and comprises a non-tapered section 150 (the cross-section of which is shown in FIG. 1B) and a tapered section 152 (the cross-section of which is shown in FIG. 1C and FIG. 1D).

The tapered section 152 is connected to an end of the non-tapered section 150. The non-tapered section 150 and the tapered section 152 are a III-V semiconductor material. In an example, this III-V semiconductor material can be p-type doped InP.

The non-tapered section 150 comprises two first sidewalls 106 that project from the substrate 104. The two first sidewalls are substantially parallel to one another. In some examples, the non-tapered section 150 can be considered as a straight section.

The tapered section 152 comprises two second sidewalls 108 that project from the substrate 104. The two second sidewalls 108 are respectively connected to the first sidewalls 106 and extend from the first sidewalls 106 and toward one another at an end of the non-tapered section 150 to define the tapered shape.

In an example, the second sidewalls 108 may be separated from one another by 5 µm at the point at which they connect to the first sidewalls 106. At the opposite end of the second sidewalls 108, away from where they connect to the first sidewalls 106, the second sidewalls 108 may be separated by 0.2 µm. The length of the tapered section may be 200 µm in such an example. The skilled person will understand that these are, however, only exemplary dimensions and that the dimensions may be varied to accommodate different material properties, substrates, thicknesses etc. The waveguide should be wide enough to contain an optical mode, but not so wide that it is multimodal. For example, at least 90% of the optical mode should be confined in the waveguide to minimize back reflection.

As can be seen between FIG. 1C and FIG. 1D, when moving though the tapered section 152, in a direction away from the non-tapered section 150, the width of the first waveguide 102 narrows in a tapering manner.

In an example, the substrate 104 can be a silicon-on-insulator (SOI) substrate, and can comprise one or more photonic components therein. For example, the substrate 104 can be arranged as an SiO₂ substrate with a silicon layer thereon, with the first waveguide then arranged in/on the silicon layer.

The waveguide structure also comprises a second waveguide 110. The second waveguide 110 is arranged under the first waveguide 102 in the substrate 104. The second waveguide 110 is arranged for the transition of an optical signal from/to the first waveguide 102 to/from the second waveguide 110.

In the example of the SOI substrate, the second waveguide 110 can be confined in the silicon layer and confined with SiO₂ buried oxide regions.

Other photonic platforms can be used in place of the SOI substrate. For example, SiN on SiO₂ or LiNBO₃, AL₂O₃ or a similar photonic platform.

The non-tapered section 152 and the tapered section 150 of the first waveguide 102 are at least partially buried in a thermally conductive cladding 112. The thermally conductive cladding 112 can be InP:Fe, for example. This can be Fe-doped InP; for example, the InP may be doped with Fe in the range of 0.1 to 2%, or preferably 1%.

A first dielectric layer 114 is arranged between the second sidewalls 108 of the tapered section 152 and the thermally conductive cladding 112 to separate the tapered section 152 from the thermally conductive cladding 112. The first dielectric layer 114 has a lower refractive index than the second waveguide 110. The first dielectric layer 114 can be considered a dielectric window.

The first dielectric layer 114 can be a polymer, such as benzocyclobutene (BCB).

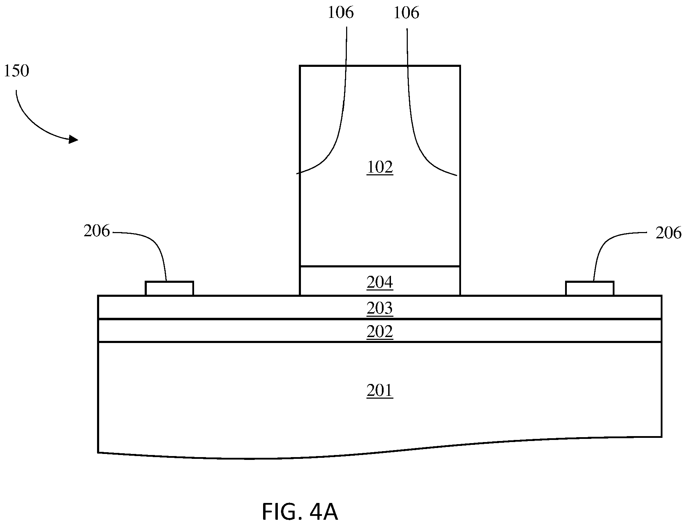

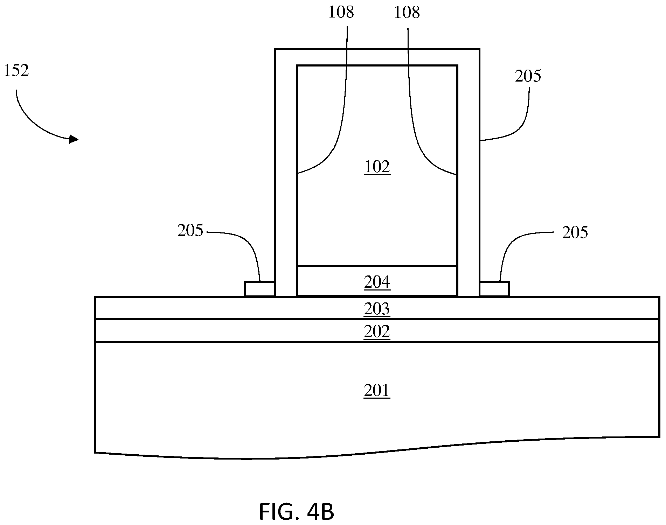

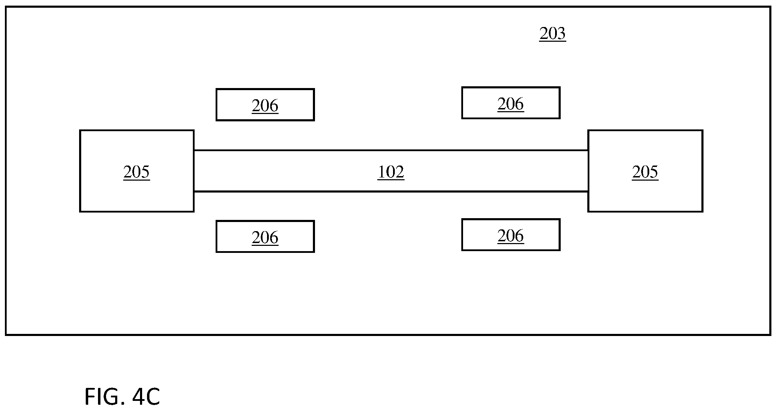

In some examples, the second sidewalls 108 of the tapered section 152 can be separated from the first dielectric layer 114 by a second dielectric layer (not shown in FIGS. 1A, 1B, 1C, but discussed subsequently with reference to FIGS. 4A, 4B and 4C onward). The second dielectric layer can be configured to prevent III-V crystalline growth on the tapered section 152. In some examples, the second dielectric layer can be SiO₂, or a silicon nitride, or another low-index dielectric.

The combination of the first dielectric layer 114 being a polymer (e.g., BCB) with the second dielectric layer 205 being a low index dielectric such as SiO₂ is advantageous over using SiO₂ alone for example as both the first and second dielectric layers. This is because tapered SiO₂ growth, surrounding the tapered section 152 is difficult to achieve; using a thin layer (e.g., ~10 nm) of SiO₂ and then also the polymer obviates this issue. Also, misalignment between the second dielectric layer 205 and the thermally conductive cladding 112 is avoided when regrowing the thermally conductive cladding 112 (e.g., by InP regrowth for InP:Fe) by the first dielectric layer 114 (i.e., the polymer) being therebetween. This allows for smooth conformal growth of the thermally conductive cladding 112.

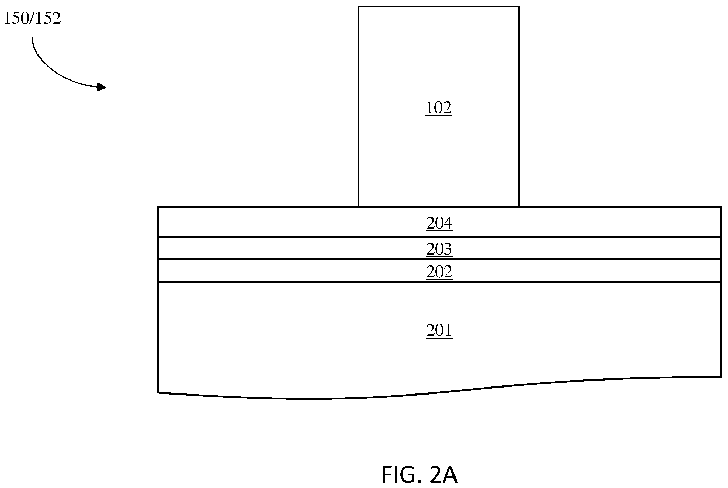

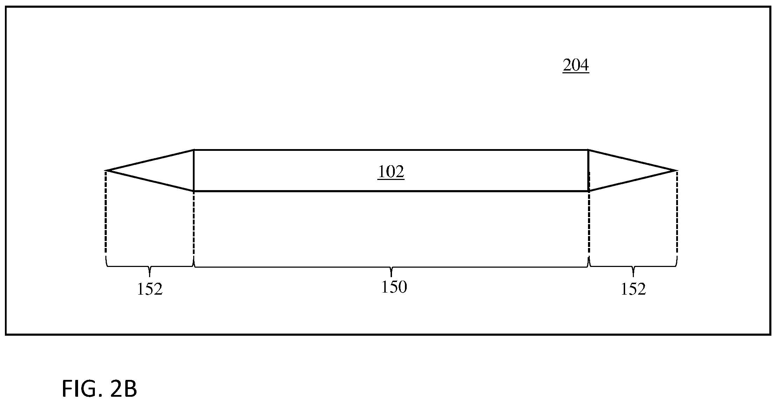

The first waveguide 102 can be arranged on an InP-based layer (not shown in FIGS. 1A, 1B, 1C, but discussed subsequently with reference to FIGS. 2A, 2B and 2C onward), with the InP-based layer arranged on the substrate 104. This InP-based layer can be n-type doped InP, for example.

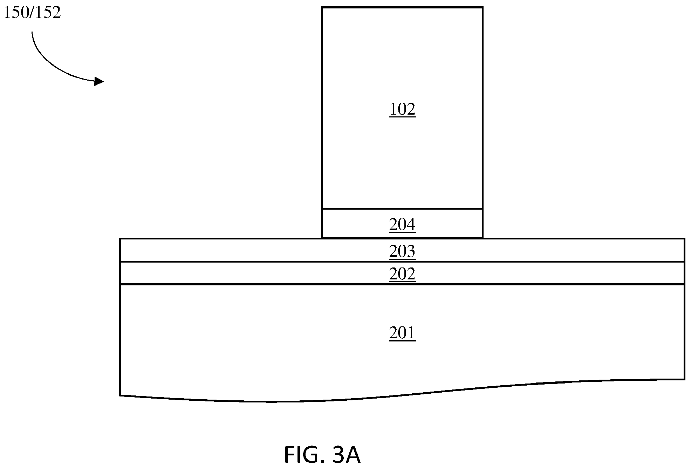

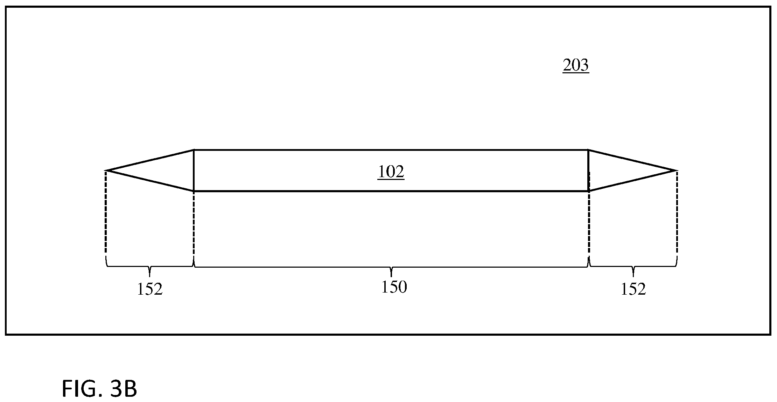

An active region (not shown in FIGS. 1A, 1B, 1C, but discussed subsequently with reference to FIGS. 3A, 3B and 3C onward) can be arranged between the first waveguide 102 and the InP-based layer. The active region can comprise quantum wells, quantum dashes, quantum dots or a similar confinement structure. The active region can comprise a III-V material. In the active region, there can be 'separate confinement heterostructures' (SCHs) which can be placed at the bottom and on top of the quantum wells/dashes/dots. These can confine the mode since they have a relatively high refractive index, and they can increase the total thickness of the active region where the mode is to be mostly confined. With the inclusion of the active region, the first waveguide 102 can be considered as an active waveguide. On the other hand, without an active region, the second waveguide 110 can be considered as a passive waveguide.

In some examples, an optical signal can be transmitted from the second waveguide 110 into the first waveguide 102, amplified using the active region, and the transmitted back into the second waveguide 110. In other examples, an optical signal can be generated in the first waveguide 102, using the active region, and then transmitted into the second waveguide 110.

In some examples, there can be a p-type contact layer (for example, an InGaAs based layer) on top of the first waveguide 102. There can be a distributed Bragg reflector (DBR) mirror at the bottom of the first waveguide 102 (e.g., on top of the active region) for when an optical feedback is wanted in the waveguide (e.g., to design lasers, for instance). For this, a thin layer can be grown, patterned, and then the III-V material (e.g., p-type doped InP) can be grown on top. Alternatively, for lasers, the top of the second waveguide 110 can be etched to define the DBR there.

While FIG. 1A shows one tapered section 152, the first waveguide 102 can have two tapered sections. The tapered section 152 shown in FIG. 1A can be considered as a first tapered section, connected to a first end of the non-tapered section 150. A second tapered section can be connected to a second end of the non-tapered section 150. The second end of the non-tapered section 150 can be considered as the opposite end of the non-tapered section 150 to the first end at which the first tapered section 152 is connected. The second tapered section can taper in a direction opposite to the direction in which the first tapered section tapers.

For example, a waveguide structure with one tapered section 152 may be implemented in a photodiode, and a waveguide structure with two tapered sections 152 may be implemented in a semiconductor optical amplifier.

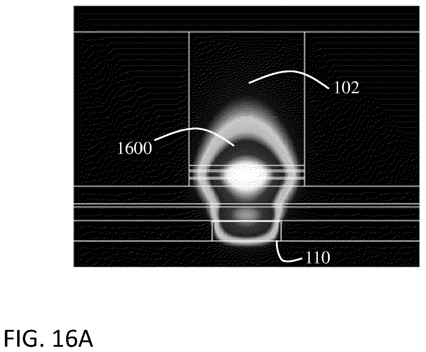

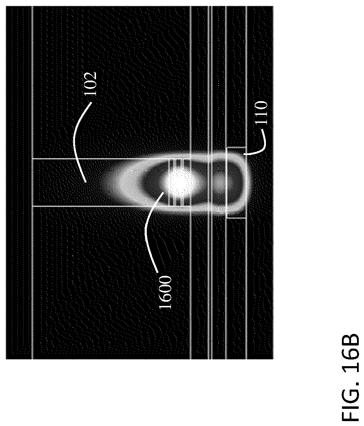

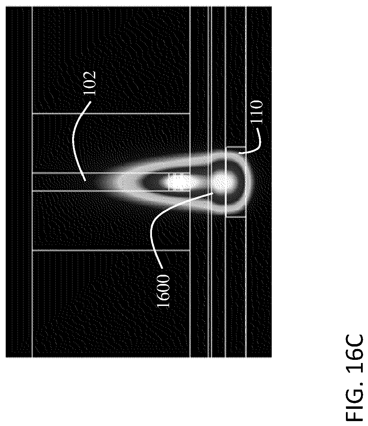

The tapered section 152 is advantageous in that it guides an optical signal from the first waveguide 102 into the second waveguide 110 (and/or from the second waveguide 110 into the first waveguide 102). FIGS. 16A, 16B and 16C show simulations of the transition of an optical signal 1600 from the first waveguide 102 into the second waveguide 110 as the first waveguide 102 narrows through the tapered section 152. From FIG. 16A to FIG. 16B, the first waveguide 102 narrows and the optical signal begins to move to the second waveguide. Then, from FIG. 16B to FIG. 16C, the first waveguide 102 narrows more, and the optical signal 1600 further transitions into the second waveguide 110.

The tapered section 152 of the first waveguide 102 can be considered as a shallow ridge adiabatic taper containing a low-refractive index cladding to enable an efficient mode transfer from/to the active region of the first waveguide 102 to/from the second waveguide 110. The non-tapered section 150 of the first waveguide 102 can be considered as a straight III-V SIBH waveguide that can contain an active gain medium (for example, quantum wells/dashes/dots) and a passivating cladding with a good thermal conductivity such as the InP:Fe.

The non-tapered section can be composed by a III-V rib waveguide that can contain the active gain material and an InP:Fe cladding. A dielectric window, formed as the dielectric layer 114, can be used in the shallow ridge adiabatic tapered section. This dielectric layer can be used to prevent regrowth of the semi-insulating cladding in the taper section, hence avoiding non-conformal overgrowth issues due to the misalignment between the taper's angle and the crystalline growth of the cladding. Moreover, having a low refractive index cladding favors optical mode coupling towards the second waveguide 110 placed underneath. For example, BCB (as the dielectric layer / window 114) has a lower refractive index than InP:Fe (as the thermally conductive cladding 112), and this can aid in transferring the optical mode from the first waveguide into the passive second waveguide.

A thin taper tip (lower than 400 nm) can be beneficial for a good optical mode transmission and a low back reflection (<-30 dB).

An advantage of the SIBH structure compared to the standalone shallow-ridge one is the superior thermal diffusion nearby the active region, which provides higher optical power. Under a high current injection, generated heat can remain localized in a ridge waveguide for a shallow-ridge device, whereas a much better diffusion is observed for the SIBH. In particular, the thermal resistance for the SIBH device can decrease by more than 40% compared to the shallow-ridge device. The SIBH device can also provide improved insertion loss in the device by reducing the refractive index contrast between the active region and its cladding; this can reduce the loss induced by the surface wall roughness at their interface. In spite of that, the tapered transition section can be designed with a shallow ridge structure to guarantee an efficient mode transfer from the III-V gain section to the passive second waveguide.

There will now be described a waveguide structure and fabrication process thereof, with regard to FIGS. 2 to 14, that includes the features of the waveguide structure of FIGS. 1A to 1D, with further features also included. It will be readily apparent that not all of these further features are necessitated in combination with one another, but different combinations of these further features can be implemented into the waveguide structure of FIGS. 1A to 1D. Common reference numerals denote common features between the waveguide structure of FIGS. 1A to 1D and that of FIGS. 2 to 14.

FIG. 2A is a cross-sectional schematic view of the waveguide structure in a first fabrication step. The cross-section is viewed along the long axis of the first waveguide 102, and can be considered to represent either the tapered section 152 or the non-tapered section 150. FIG. 2B is a top-down schematic view of the waveguide structure in the first fabrication step.

The structure of FIGS. 2A and 2B has a first substrate 201. The first substrate can be, for example, an InP substrate.

A sacrificial layer 202 can be arranged on the first substrate 201. The sacrificial layer 202 can be, for example, n-type doped silicon.

An n-type doped InP layer 203 can be arranged on the sacrificial layer 202.

An active layer 204 can be arranged on the n-type doped InP layer 203. The active layer 204 can be comprise quantum wells, quantum dashes, quantum dots or a similar confinement structure. The active layer 204 can comprise a III-V material. The active layer 204 can correspond to the active region described with reference to FIGS. 1A to 1D.

The first waveguide 102 is arranged on the active layer 204. The first waveguide 102 has a non-tapered section 150, and two tapered sections 152. The two tapered sections 152 are arranged at opposing ends of the non-tapered section 150. Other details pertaining to the first waveguide 102 correspond to those already described with reference to FIGS. 1A to 1D; the details are not repeated here for brevity.

In some examples, the first waveguide can be formed from a III-V layer (e.g., p-type doped InP) that substantially covers the active layer 204. This III-V layer can undergo a mesa patterning step, that can comprise inductively coupled plasma (ICP) and wet etching, to define the shape of the first waveguide 102, including the non-tapered section 150 and tapered sections 152, by removing portions of the III-V layer, thereby exposing the active layer 204.

FIG. 3A is a cross-sectional schematic view of the waveguide structure in a second fabrication step. The cross-section is viewed along the long axis of the first waveguide 102, and can be considered to represent either the tapered section 152 or the non-tapered section 150. FIG. 3B is a top-down schematic view of the waveguide structure in the second fabrication step.

In the second fabrication step, the active layer 204 is etched (for example with ICP and wet etching) so that the regions of the active layer 204 that are not under the first waveguide 102 are removed. In this way, the n-type doped InP layer 203 is exposed, and the active region is defined.

FIG. 4A is a cross-sectional schematic view of the non-tapered section 150 of the waveguide structure in a third fabrication step. FIG. 4B is a cross-sectional schematic view of the tapered section 152 of the waveguide structure in the third fabrication step. The cross-sections are viewed along the long axis of the first waveguide 102. FIG. 4C is a top-down schematic view of the waveguide structure in the third fabrication step.

In the third fabrication step, the second dielectric layer 205 (discussed with reference to FIGS. 1A to 1D) is applied to the second sidewalls 108 of the tapered section 152, and to the top surface of the first waveguide 102 in the tapered section 152. The top surface can be considered the surface of the first waveguide 102 opposing the surface in contact with the active layer 204. In some examples, the second dielectric layer 205 can be SiO₂, or a silicon nitride, or another low-index dielectric.

The second dielectric layer 205 also partially covers a region on the n-type doped InP layer 203 immediately adjacent to, and surrounding, the second sidewalls 108 of the tapered section 152 of the first waveguide 102 (best seen in FIG. 4C). In this way, a region is defined between the second sidewalls 108 of the tapered section 152 and the n-type doped InP layer 203; this is used subsequently to prevent III-V regrowth immediately adjacent to the tapered section of the first waveguide, providing vias or channels between regrown III-V material and the tapered section 150.

In the third fabrication step, islands 206 of dielectric material (e.g., the same dielectric material as used for the second dielectric layer) are deposited on the n-type doped InP layer alongside but separated from the non-tapered section 150 of the first waveguide 102. These islands 206 can be used subsequently to prevent III-V regrowth, thereby forming vias or channels.

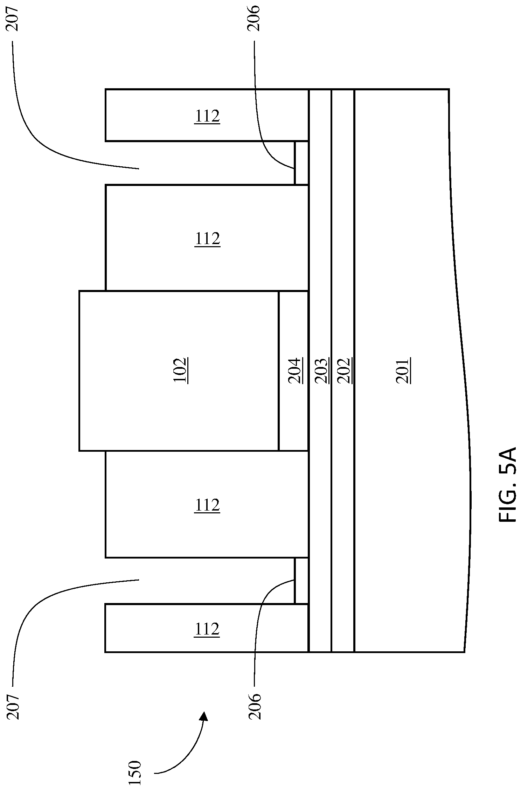

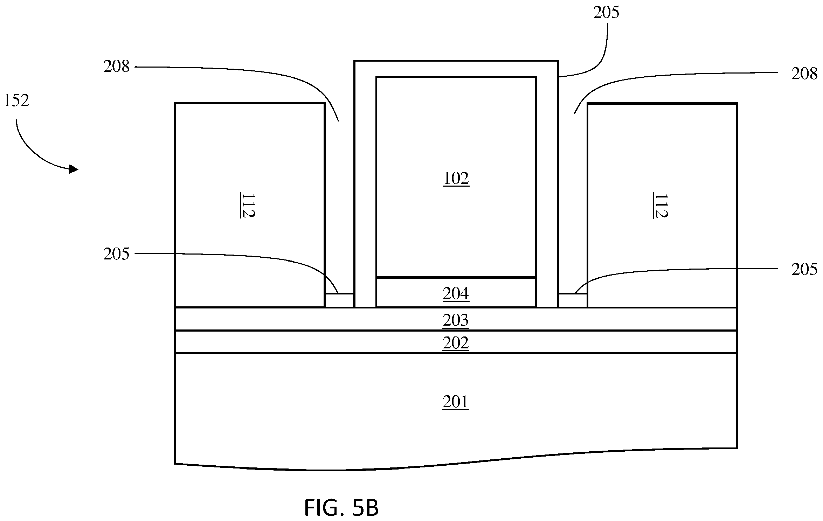

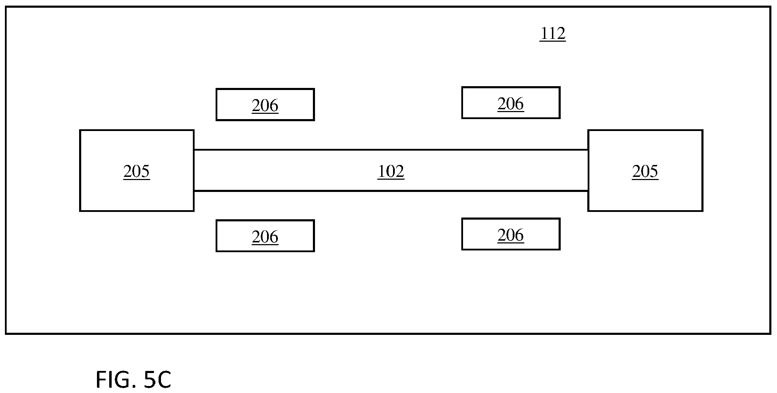

FIG. 5A is a cross-sectional schematic view of the non-tapered section 150 of the waveguide structure in a fourth fabrication step. FIG. 5B is a cross-sectional schematic view of the tapered section 152 of the waveguide structure in the fourth fabrication step. The cross-sections are viewed along the long axis of the first waveguide 102. FIG. 5C is a top-down schematic view of the waveguide structure in the fourth fabrication step.

In the fourth fabrication step, the thermally conductive cladding 112 can be deposited on the n-type InP layer 203, for example through III-V regrowth. As discussed with reference to FIGS. 1A to 1D, the thermally conductive cladding 112 can be InP:Fe, for example.

The thermally conductive cladding 112 selectively grows on the n-type InP layer, and not on the second dielectric layer 205 on the second sidewalls 108 of the tapered region 152.

The thermally conductive cladding 112 does not grow on the region of second dielectric 205 adjacent to, and surrounding, the second sidewalls 108 of the tapered section 152 of the first waveguide 102. As such, windows 208 in the thermally conductive cladding 112 are defined adjacent to, and surrounding, the second sidewalls 108 of the tapered section 152 of the first waveguide 102.

Furthermore, the thermally conductive cladding 112 does not grow on the islands 206 of the second dielectric alongside but separated from the non-tapered section 150 of the first waveguide 102. In this way, vias 207 are defined through the thermally conductive cladding.

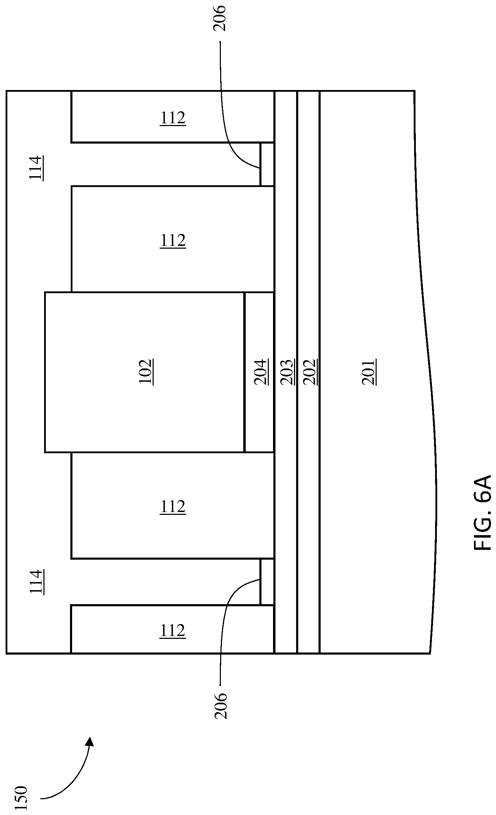

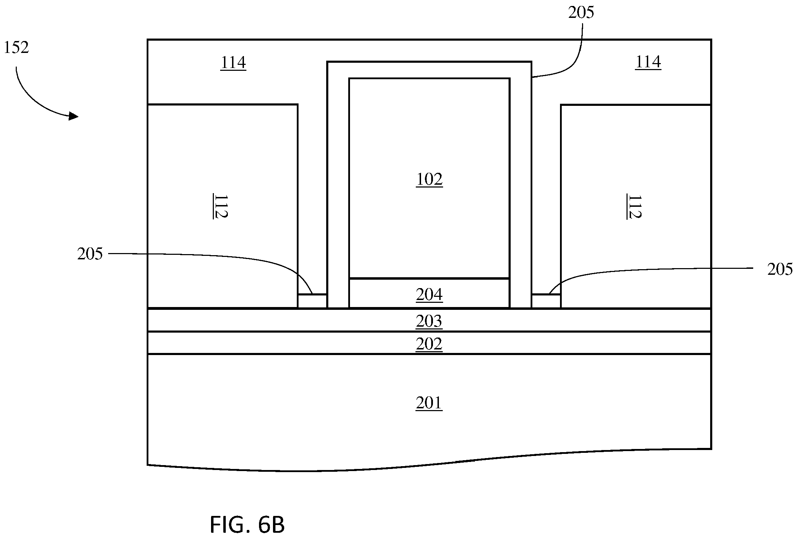

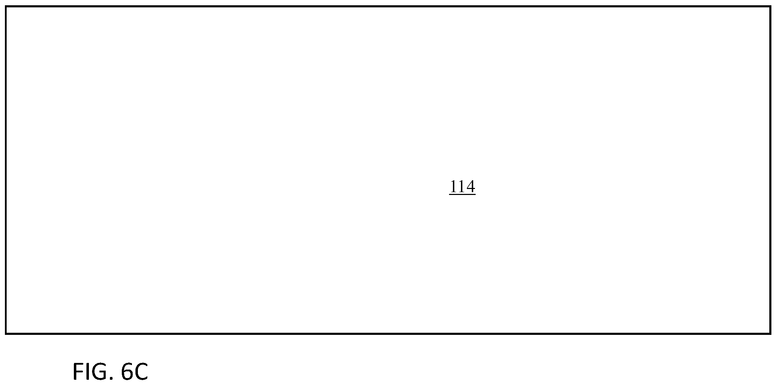

FIG. 6A is a cross-sectional schematic view of the non-tapered section 150 of the waveguide structure in a fifth fabrication step. FIG. 6B is a cross-sectional schematic view of the tapered section 152 of the waveguide structure in the fifth fabrication step. The cross-sections are viewed along the long axis of the first waveguide 102. FIG. 6C is a top-down schematic view of the waveguide structure in the fifth fabrication step.

In the fifth fabrication step, the first dielectric layer 114 is deposited on the structure. As discussed with reference to FIGS. 1A to 1D, the first dielectric layer 114 can be a polymer, such as BCB; the other details from FIGS. 1A to 1D regarding the first dielectric layer 114 also apply here, but are not repeated for brevity. In an example, the first dielectric layer 114, which can be a polymer such as BCB, can be deposited on the structure by spin-coating.

The first dielectric layer 114 can substantially cover the first waveguide 102 and the thermally conductive cladding 112, including filling the windows 208 and the vias 207.

The top surface of the first dielectric layer 114 (i.e., the surface of the first dielectric layer 114 opposite to the surface in contact with the first waveguide 102 and the thermally conductive cladding 112) can be planarized to provide a substantially flat surface.

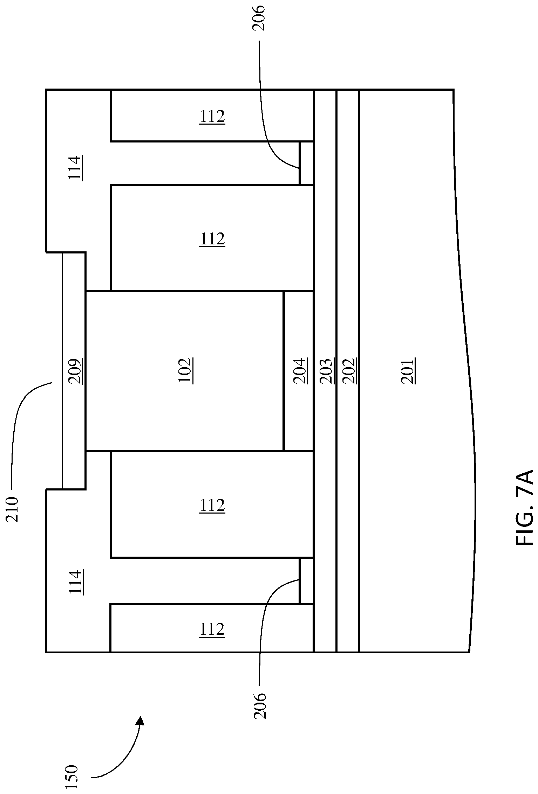

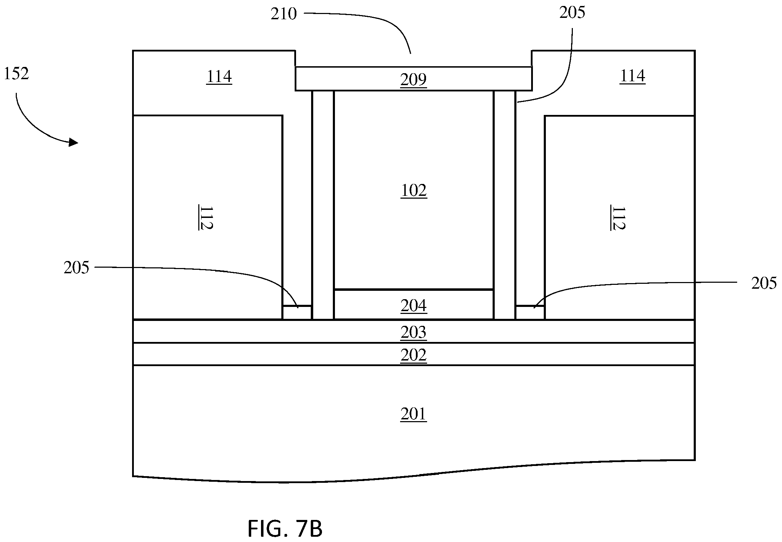

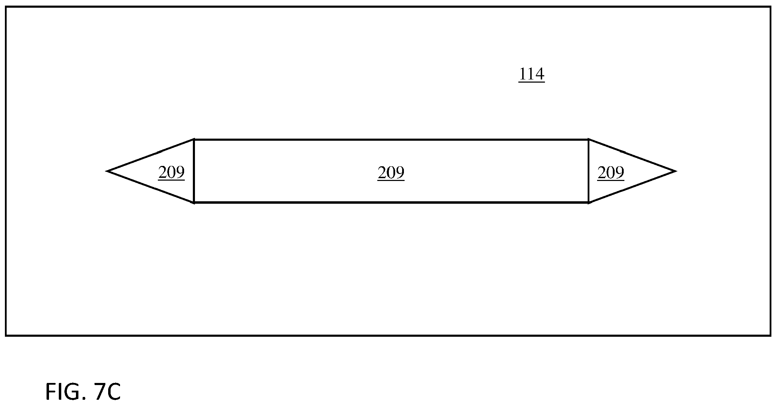

FIG. 7A is a cross-sectional schematic view of the non-tapered section 150 of the waveguide structure in a sixth fabrication step. FIG. 7B is a cross-sectional schematic view of the tapered section 152 of the waveguide structure in the sixth fabrication step. The cross-sections are viewed along the long axis of the first waveguide 102. FIG. 7C is a top-down schematic view of the waveguide structure in the sixth fabrication step.

In the sixth fabrication step, a recess 210 is etched in the top surface of the first dielectric layer 114 above the first waveguide 102.

Above the non-tapered section 150 of the first waveguide 102, the first dielectric layer 114 is etched through to the top surface of the first waveguide 102 (i.e., the surface of the waveguide opposite to the surface arranged on the active region 204), thereby exposing the top surface of the first waveguide 102 in the non-tapered section 150.

Above the tapered section 152 of the first waveguide 102, the first dielectric layer 114 is etched and the region of the second dielectric layer 205 on the top surface of the first waveguide 102 is also etched, thereby exposing the top surface of the first waveguide 102 in the tapered section 152.

The etched recess 210 above both the non-tapered section 150 and the tapered section 152 of the first waveguide 102 can have a width that is wider than the width of the first waveguide 102 in these regions.

The etched recess 210 can then be at least partially filled with a metal contact layer 209 (for example, gold, copper, aluminium or the like) that covers the exposed top surface of the first waveguide 102 in both the non-tapered section 150 and the tapered section 152. The structure can then be annealed.

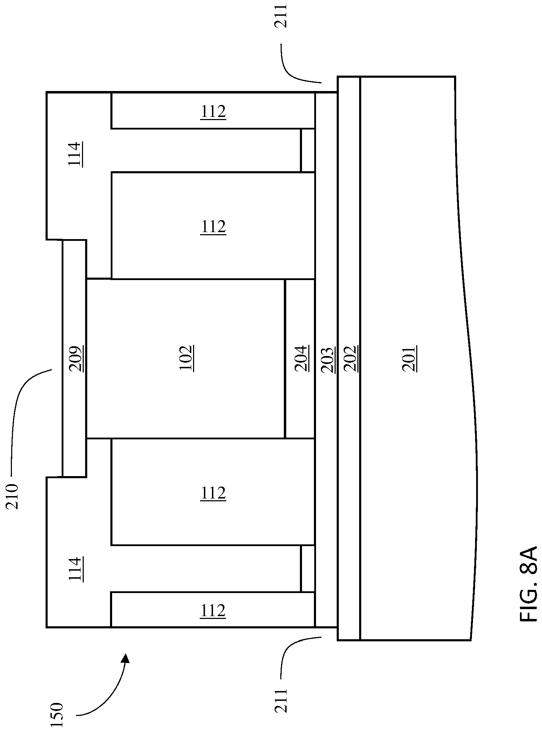

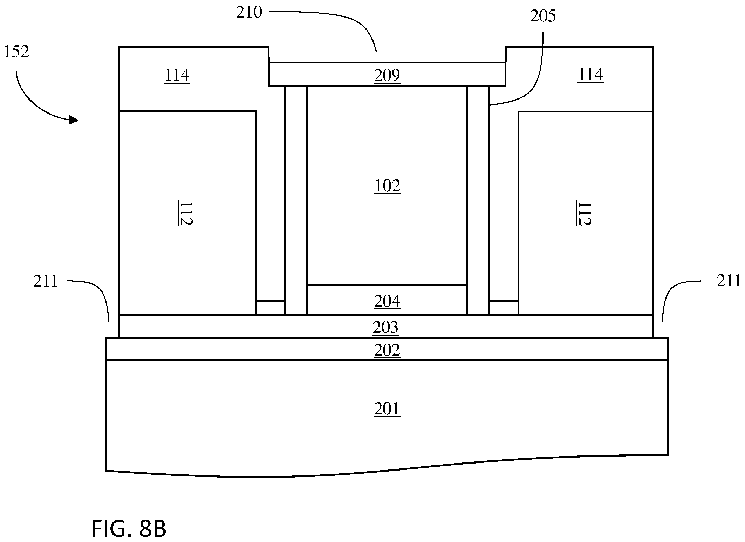

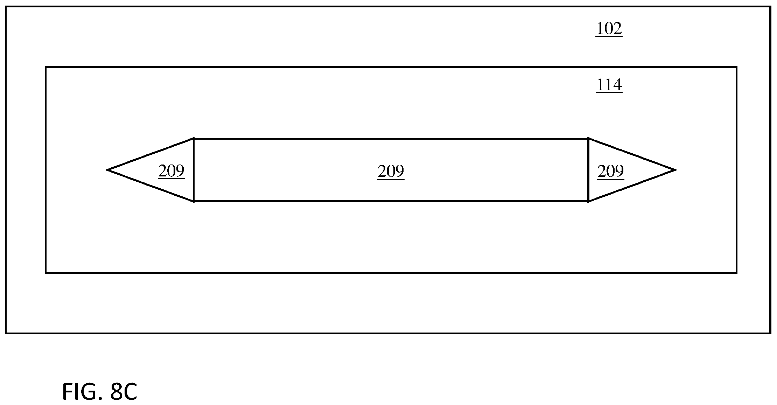

FIG. 8A is a cross-sectional schematic view of the non-tapered section 150 of the waveguide structure in a seventh fabrication step. FIG. 8B is a cross-sectional schematic view of the tapered section 152 of the waveguide structure in the seventh fabrication step. The cross-sections are viewed along the long axis of the first waveguide 102. FIG. 8C is a top-down schematic view of the waveguide structure in the seventh fabrication step.

In the seventh fabrication step, a mesa etching is performed to define an area around the first waveguide 102. A region surrounding the first waveguide 102, but separated from the first waveguide is etched through to the sacrificial layer 203, thereby exposing the sacrificial layer 202 at the periphery of the waveguide structure. That is, in both the non-tapered section 150 and the tapered section 152, a portion 211 is recessed by etching though the first dielectric layer 114, the thermally conductive cladding 112, and the n-type doped InP layer 203, to the sacrificial layer 202.

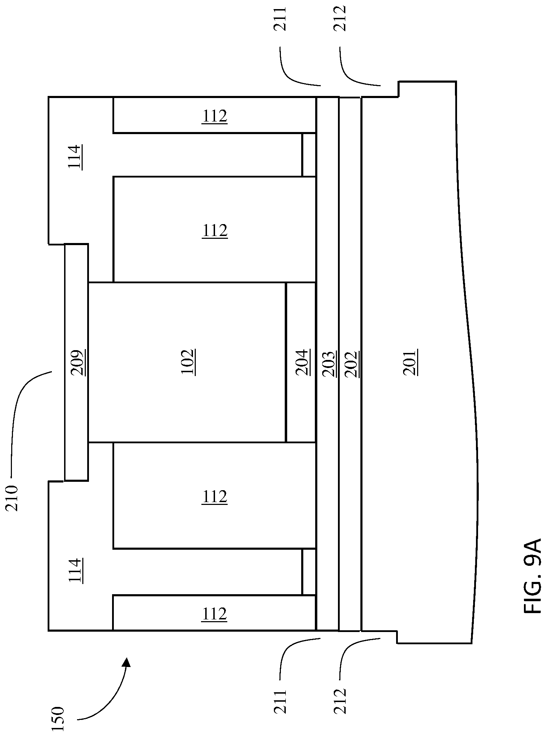

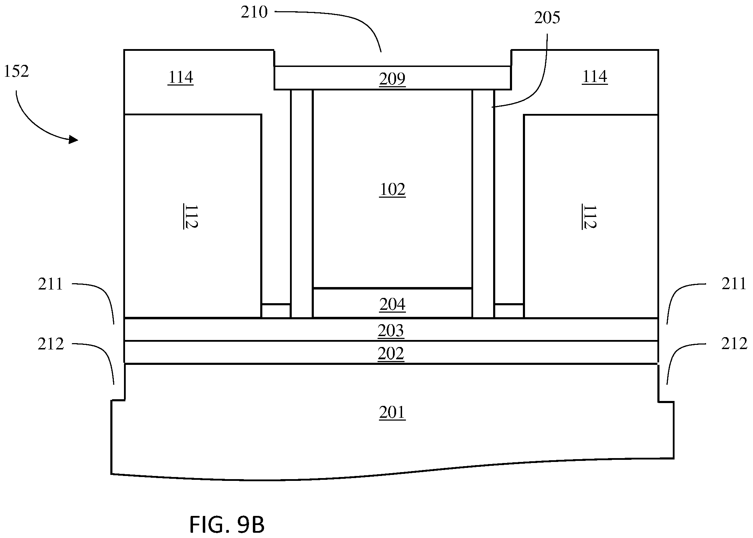

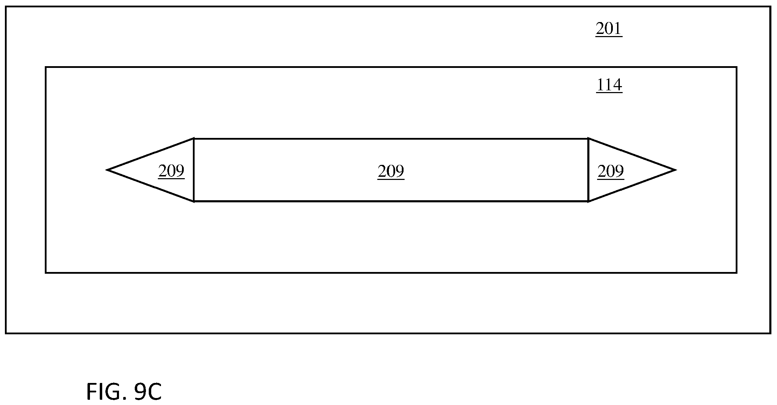

FIG. 9A is a cross-sectional schematic view of the non-tapered section 150 of the waveguide structure in an eighth fabrication step. FIG. 9B is a cross-sectional schematic view of the tapered section 152 of the waveguide structure in the eighth fabrication step. The cross-sections are viewed along the long axis of the first waveguide 102. FIG. 9C is a top-down schematic view of the waveguide structure in the eighth fabrication step.

In the eighth fabrication step, the etching of the seventh fabrication step is continued deeper into the structure such that a portion 212 is etched through the sacrificial layer 202 and partially through the InP substrate 201. The etched portion 212 in the eighth fabrication step is under and can be aligned with the etched portion 211 from the seventh fabrication step. In this way, the InP substrate 201 is exposed at the periphery of the waveguide structure.

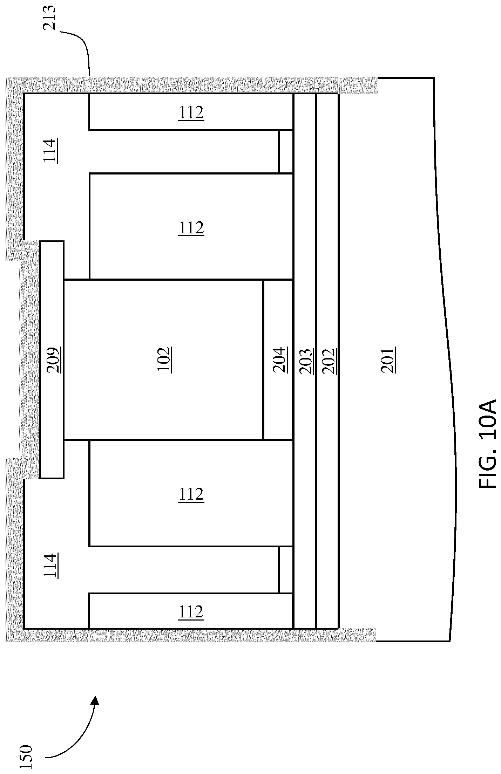

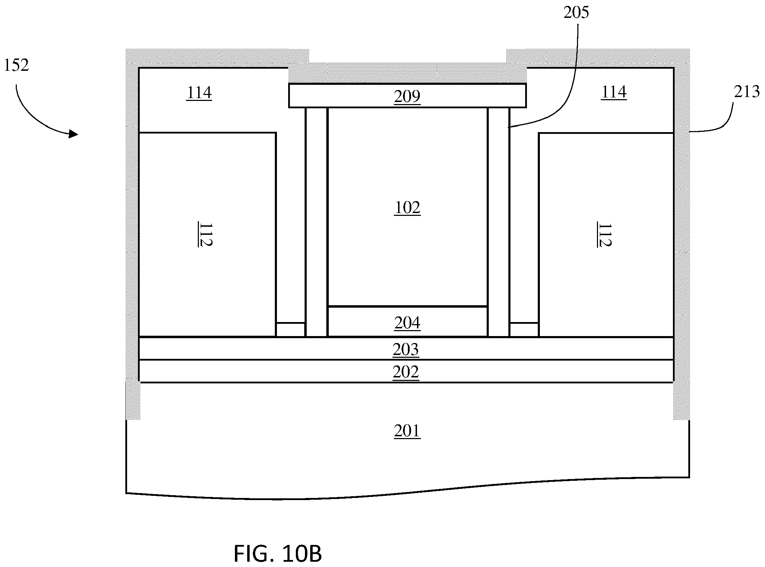

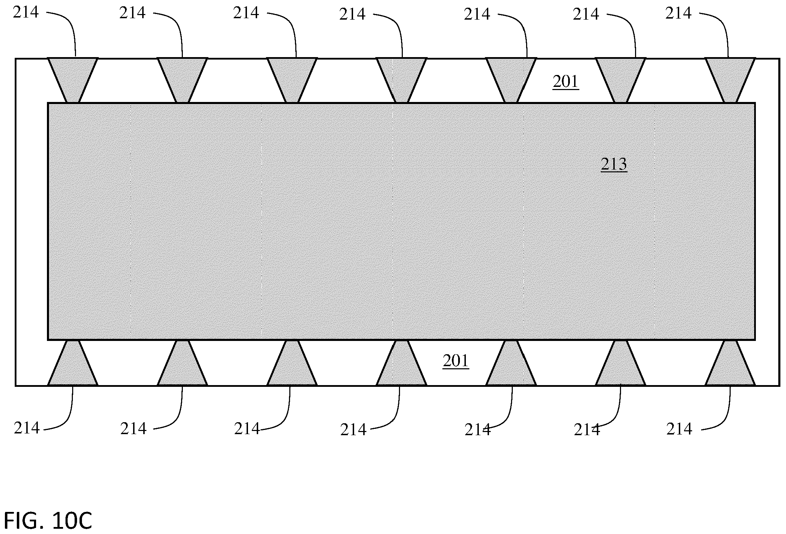

FIG. 10A is a cross-sectional schematic view of the non-tapered section 150 of the waveguide structure in a ninth fabrication step. FIG. 10B is a cross-sectional schematic view of the tapered section 152 of the waveguide structure in the ninth fabrication step. The cross-sections are viewed along the long axis of the first waveguide 102. FIG. 10C is a top-down schematic view of the waveguide structure in the ninth fabrication step.

In the ninth fabrication step, an encapsulation layer 213 is deposited on the waveguide structure. The encapsulation layer 213 can cover the top surface of the waveguide structure (that is the topmost surface away from the InP substrate 201), and can fill the etched portion 211 and the etched portion 212. In an example, the encapsulation layer can be silicon nitride.

In some examples, the encapsulation layer 213 may not cover the waveguide structure completely to the edge of the substrate. At the edge regions of the waveguide structure, a plurality of tethers 214 can be defined. These tethers 214 can also be silicon nitride. The tethers are configured to anchor the first waveguide 102 and the features other than the InP substrate 201 and sacrificial layer 202 onto the InP substrate 201 before transfer printing, as will be discussed in more detail subsequently with regard to the twelfth fabrication step.

For visual ease the tethers 214 are shown in the top-down view of FIG. 10C, but not the cross-sectional views of FIGS. 10A and 10B. The tethers can be of a substantially triangular shape, with the apex of the triangle connected to the encapsulation layer 213.

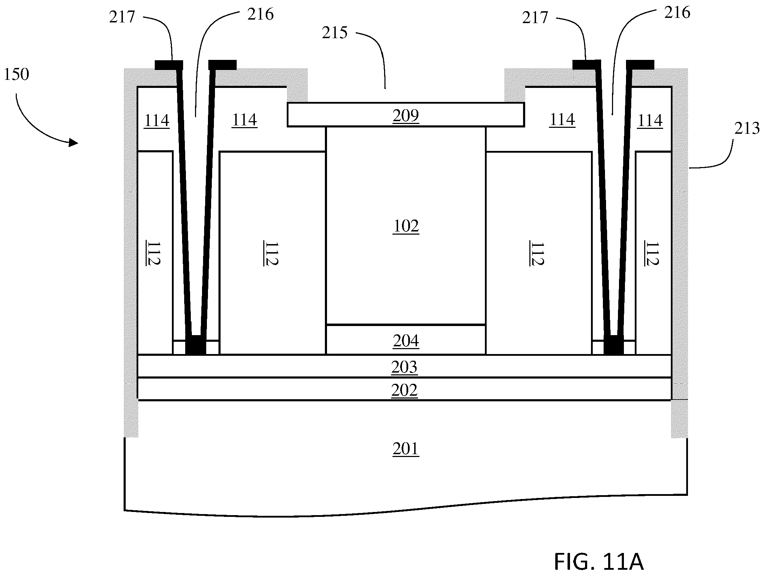

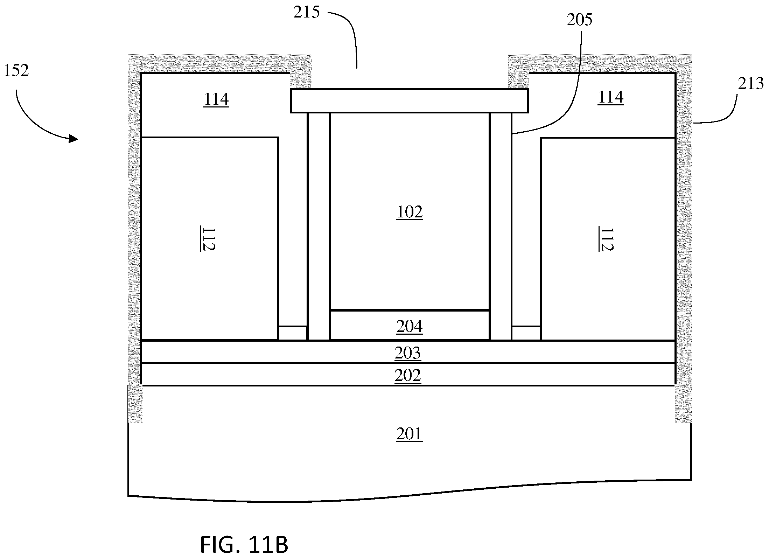

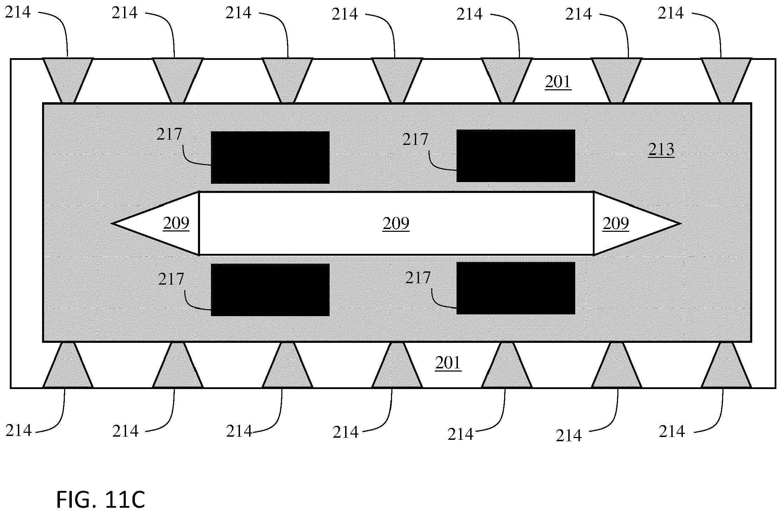

FIG. 11A is a cross-sectional schematic view of the non-tapered section 150 of the waveguide structure in a tenth fabrication step. FIG. 11B is a cross-sectional schematic view of the tapered section 152 of the waveguide structure in the tenth fabrication step. The cross-sections are viewed along the long axis of the first waveguide 102. FIG. 11C is a top-down schematic view of the waveguide structure in the tenth fabrication step.

In the tenth fabrication step, in both the non-tapered section 150 and the tapered section 152, a region 215 of the encapsulation layer 213 above the first waveguide 102 can be etched through to the metal contact layer 209, so that the metal contact layer 209 is exposed.

In the non-tapered section 150, vias 216 can also be etched through the encapsulation layer 213, through the first dielectric layer 114, and through the dielectric islands 206 to connect through to the n-type doped InP layer 203. These vias 216 can then be filled, for example on their inner walls, with a metal layer 217 by metal deposition. The metal can also be deposited in the etched opening through the dielectric islands 206, and also around the openings to the vias 216 formed by the etch in the top surface of the encapsulation layer 213.

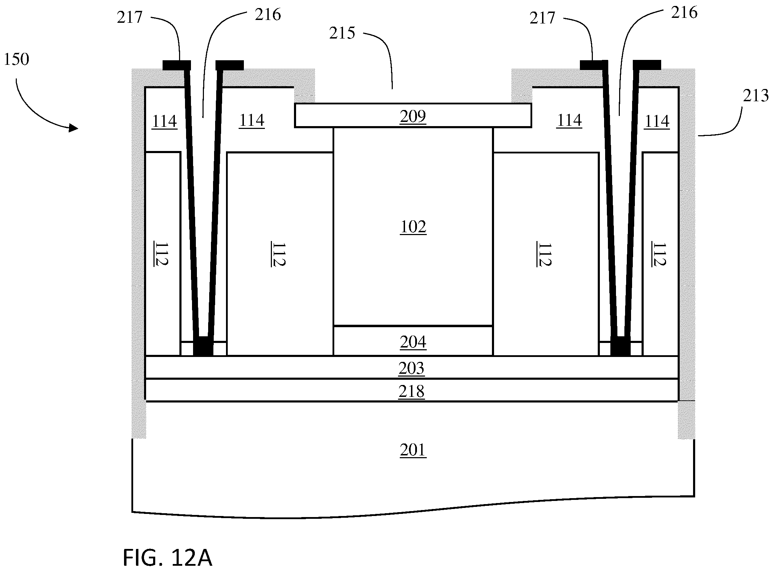

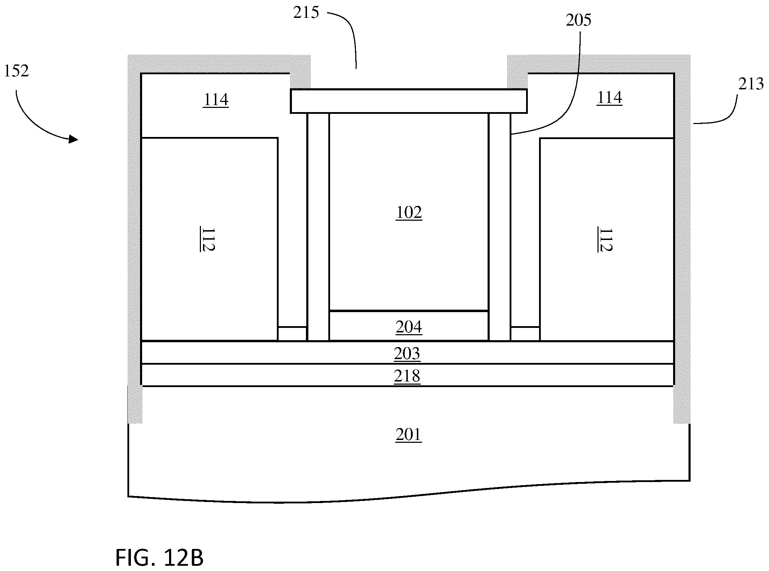

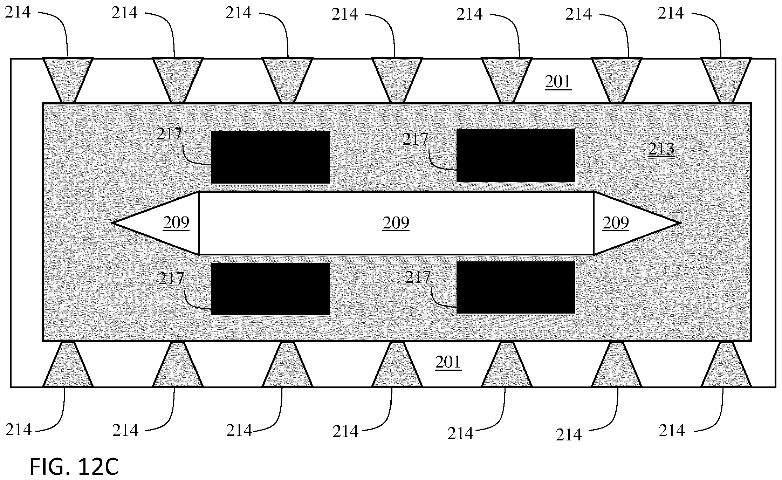

FIG. 12A is a cross-sectional schematic view of the non-tapered section 150 of the waveguide structure in an eleventh fabrication step. FIG. 12B is a cross-sectional schematic view of the tapered section 152 of the waveguide structure in the eleventh fabrication step. The cross-sections are viewed along the long axis of the first waveguide 102. FIG. 12C is a top-down schematic view of the waveguide structure in the eleventh fabrication step.

In the eleventh fabrication step, the sacrificial layer 202 can etched, leaving a cavity 218 between the n-doped InP layer 203 and the InP substrate 201.

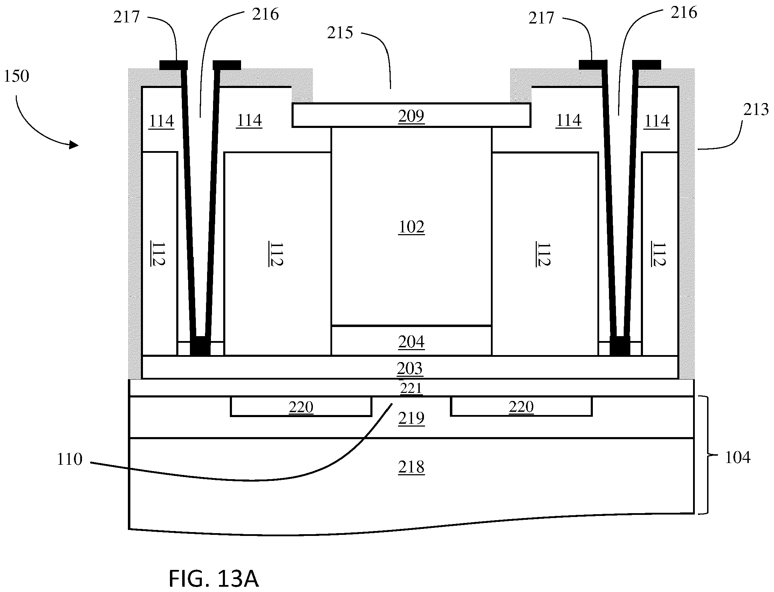

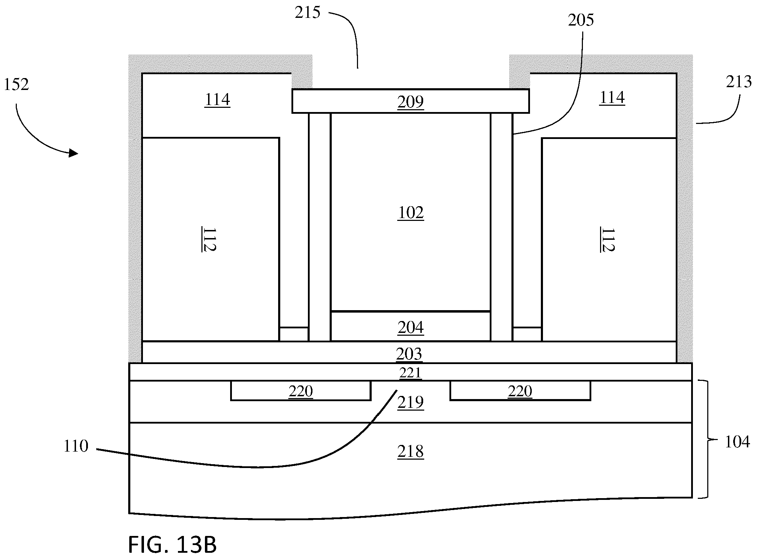

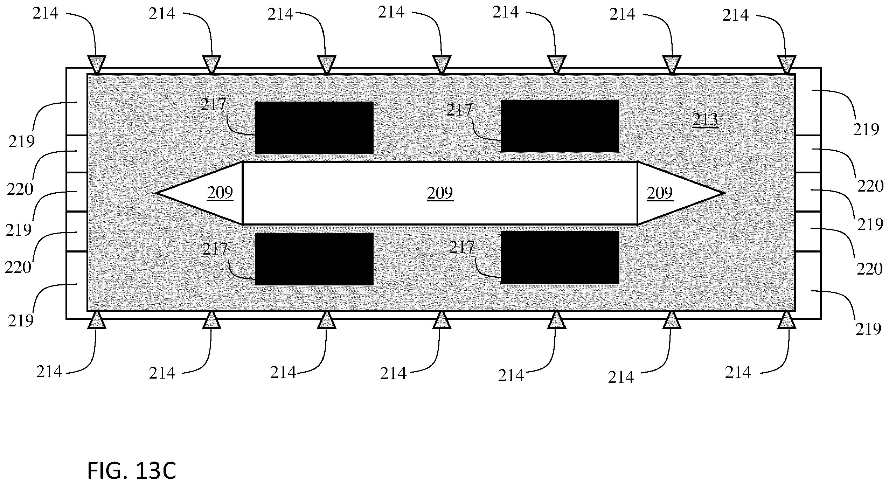

FIG. 13A is a cross-sectional schematic view of the non-tapered section 150 of the waveguide structure in a twelfth fabrication step. FIG. 13B is a cross-sectional schematic view of the tapered section 152 of the waveguide structure in the twelfth fabrication step. The cross-sections are viewed along the long axis of the first waveguide 102. FIG. 13C is a top-down schematic view of the waveguide structure in the twelfth fabrication step.

In the twelfth fabrication step, the waveguide structure is released from the InP substrate 201. That is, the features other than the InP substrate can be separated from the InP substrate 201. This is aided by the etching of the sacrificial layer 202 in the eleventh step.

The released waveguide structure is then deposited on a substrate 104. The substrate 104 corresponds to the substrate 104 described with reference to FIGS. 1A to 1D.

This release from the InP substrate 201 and arranging on the substrate 104 can be facilitated by micro-transfer printing.

As described with reference to FIGS. 1A to 1D, the substrate 104 can be a SOI substrate, and can comprise one or more photonic components therein. For example, the substrate 104 can be arranged as an SiO₂ substrate 218 with a silicon layer 219 thereon.

In other examples, other photonic platforms can be used. For example, these could include SiN on SiO₂, or LiNBO₃, or Al₂O₃, or a similar photonic platform.

The released waveguide can be adhered to the substrate 104 by a bonding layer 221. In an example, this bonding layer 221 can be a thin layer of dielectric, such as BCB (e.g., in the range of 20 to 30 nm thickness); using a thin layer has a negligible impact on the thermal properties of the structure. In other examples, the released waveguide can be adhered to the substrate 104 by hydrogen bonds (for example, using planarized surfaces to allow adequate bonding).

In the example of FIGS. 13A and 13B, the second waveguide 110 is arranged in the silicon layer 219, confined between two buried oxide strips 220. These buried oxide strips 220 can be SiO₂, for example. The buried oxide strips 220 can extend through the SOI substrate 104 in the same direction as the long axis of the first waveguide 102.

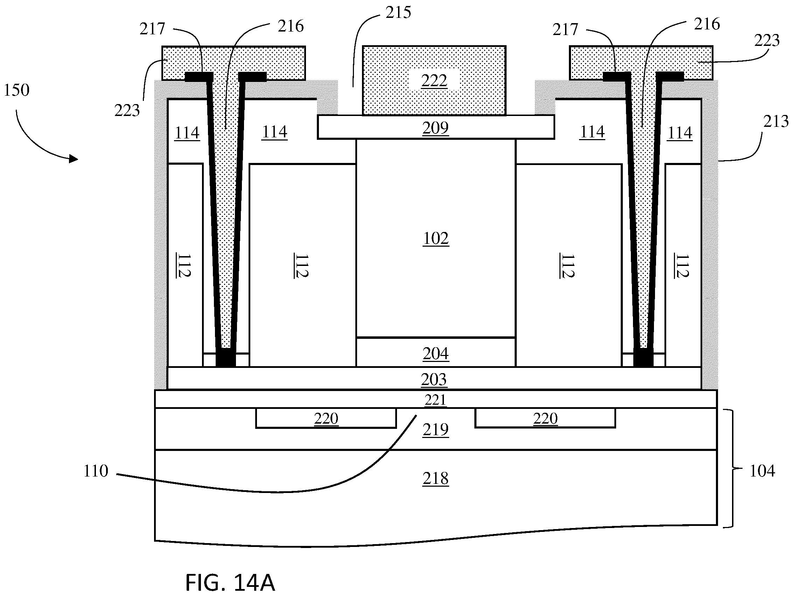

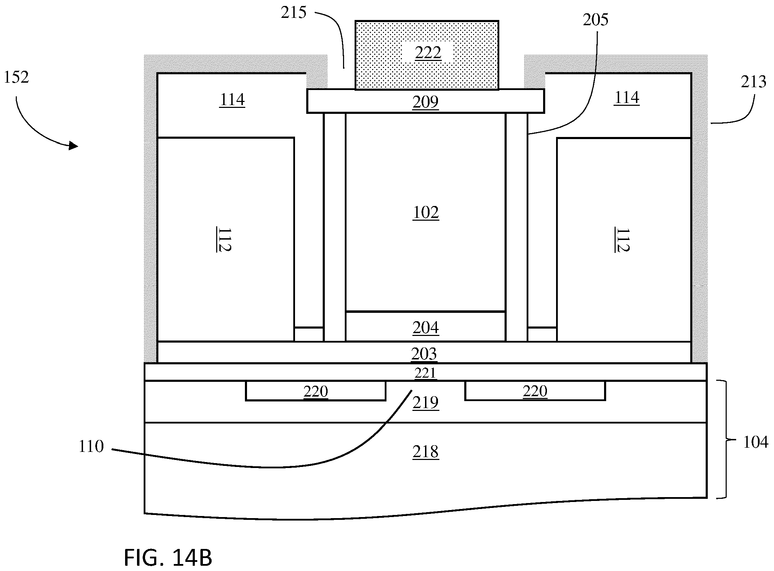

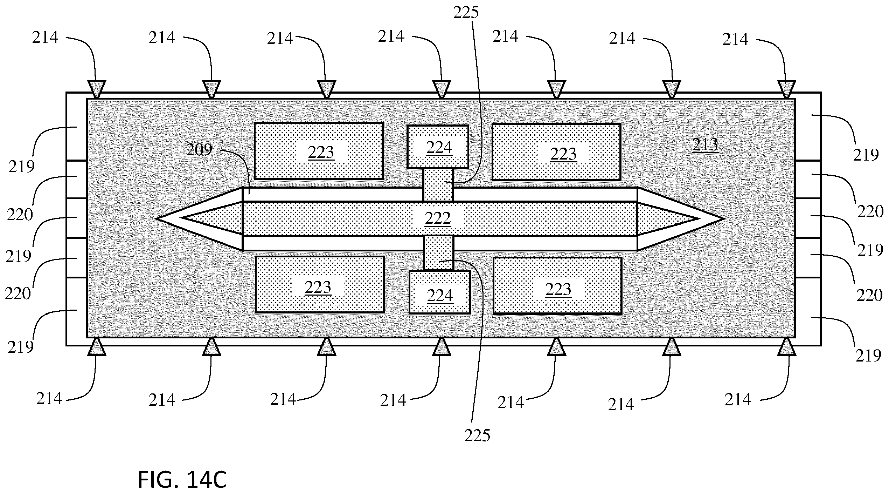

FIG. 14A is a cross-sectional schematic view of the non-tapered section 150 of the waveguide structure in a thirteenth fabrication step. FIG. 14B is a cross-sectional schematic view of the tapered section 152 of the waveguide structure in the thirteenth fabrication step. The cross-sections are viewed along the long axis of the first waveguide 102. FIG. 14C is a top-down schematic view of the waveguide structure in the thirteenth fabrication step.

In the thirteenth fabrication step, a first pad 222 is deposited on top of the metal contact layer 209 in both the non-tapered section 150 and the tapered section 152. The first pad 222 can substantially cover the metal contact layer 209 and extend from the metal contact layer 209. In an example, the first pad 222 can be metal, such as gold or copper.

The vias 216 in the non-tapered section 150 can also be filled with a metal (e.g., gold or copper), and second pads 223 can be arranged above/over these filled vias, extending from the top surface of the encapsulation layer 213.

The first pad 222 provides electrical connection to the p-typed doped InP of the first waveguide 102. The second pads 223 provide electric connection to the n-type doped InP layer 203. Additional pads 224 (not shown in the cross-sectional views) can be deposited on the top surface of the encapsulation layer 213, and connected to the first pad 222 by an electrical bridge 225. The additional pads 224 and electrical bridges 225 can also be a metal such as copper or gold. These additional pads 224 and electrical bridges 225 can be used to provide an electrical connection to the first pad 222 and/or the first waveguide 102.

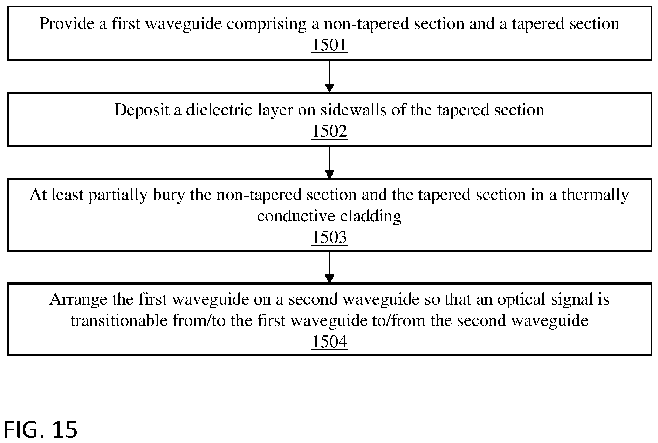

FIG. 15 is a flow chart of an exemplary methodology, based upon the fabrication described with reference to FIGS. 2 to 14, but in generalised terms, for fabricating the waveguide structure of FIGS. 1A to 1D. It will be readily apparent to the skilled person that features described with reference to FIGS. 2 to 14, and the waveguide structure of FIGS. 1A to 1D, can be readily implemented in the process of FIG. 15.

At step 1501, the first waveguide 102 comprising the non-tapered section 150 and the tapered section 152 is provided. As discussed with reference to FIGS. 1A to 1D, the first waveguide 102 is a SIBH. The tapered section 152 is connected to an end of the non-tapered section 150. The non-tapered section 150 and the tapered section 152 are a III-V semiconductor material. The non-tapered section 150 comprises two first sidewalls 106 that are substantially parallel to one another. The tapered section 152 comprises two second sidewalls 108 that are respectively connected to the first sidewalls 106 and extend from the first sidewalls 106 at an end of the non-tapered section 152 toward one another to define the tapered shape.

At step 1502, the dielectric layer 114 is deposited on the second sidewalls 108 of the tapered section 152.

In some examples, before depositing the dielectric layer 114, the method can also comprise depositing the second dielectric layer 205 on the second sidewalls 108 of the tapered section 152, wherein the second dielectric layer 205 is then arranged between the second sidewalls 108 and the dielectric layer 114, and the second dielectric layer 205 is configured to prevent III-V crystalline growth thereon.

At step 1503, the non-tapered section 150 and the tapered section 12 are at least partially buried in the thermally conductive cladding 112. The dielectric layer 114 is arranged between the second sidewalls 108 and the thermally conductive cladding 112 to separate the tapered section from the thermally conductive cladding 112.

At step 1504, the first waveguide 102 is arranged on the second waveguide 104 so that an optical signal is transitionable from/to the first waveguide 102 to/from the second waveguide 104, wherein the dielectric layer 114 has a lower refractive index than the second waveguide 104.

The waveguide structure described in the present disclosure can find application in different types of electronic/optoelectronic device.

In a first example a semiconductor optical amplifier can comprise the waveguide structure as described herein.

In a second example, a laser can comprise the waveguide structure as described herein.

In a third example, a photodiode can comprise the waveguide structure as described herein.

In a fourth example, a modulator can comprise the waveguide structure as described herein.

Although the foregoing description has been set out with reference to particular examples, it is to be understood that these examples are merely illustrative of the principles and applications of the present disclosure. It is therefore to be understood that numerous modifications can be made to the illustrative examples and that other arrangements can be devised without departing from the spirit and scope of the disclosure as determined based upon the claims and any equivalents thereof.

## Claims

1. A waveguide structure comprising:
a first waveguide (102) arranged on a substrate (104), wherein the first waveguide is a semi-insulating buried heterostructure, SIBH, comprising a non-tapered section (150) and a tapered section (152), the tapered section connected to an end of the non-tapered section, and the non-tapered section and the tapered section being a III-V semiconductor material, the non-tapered section comprising two first sidewalls (106) projecting from the substrate, wherein the two first sidewalls are substantially parallel to one another, the tapered section comprising two second sidewalls (108) projecting from the substrate, wherein the two second sidewalls are respectively connected to the first sidewalls and extend from the first sidewalls at an end of the non-tapered section toward one another to define a tapered shape;
a second waveguide (110), wherein the second waveguide is under the first waveguide in the substrate and arranged for transition of an optical signal from/to the first waveguide to/from the second waveguide;
a thermally conductive cladding (112), wherein the non-tapered section and the tapered section of the first waveguide are at least partially buried in the thermally conductive cladding; and
a dielectric layer (114) between the second sidewalls of the tapered section and the thermally conductive cladding to separate the tapered section from the thermally conductive cladding, wherein the dielectric layer has a lower refractive index than the second waveguide.

2. The waveguide structure of claim 1, wherein the dielectric layer is a polymer layer.

3. The waveguide structure of any preceding claim, wherein the second sidewalls are separated from the dielectric layer by a second dielectric layer (205) that is configured to prevent III-V crystalline growth thereon.

4. The waveguide structure of any preceding claim, wherein the tapered section is a first tapered section connected to a first end of the non-tapered section, and the first waveguide further comprises a second tapered section connected to a second end of the non-tapered section, wherein the second end of the non-tapered section is an opposite end to the first end, and wherein the second tapered section tapers in a direction opposite to a direction in which the first tapered section tapers.

5. The waveguide structure of any preceding claim, wherein the first waveguide is arranged on an InP-based layer (203), and the InP-based layer is arranged on the substrate.

6. The waveguide structure of claim 5, wherein an active region (204) is arranged between the first waveguide and the InP-based layer.

7. The waveguide structure of any preceding claim, wherein the III-V semiconductor material of the first waveguide is p-type doped InP.

8. The waveguide structure of any preceding claim, wherein the thermally conductive cladding comprises InP:Fe.

9. The waveguide structure of any preceding claim, wherein the substrate is a silicon-on-insulator, SOI, substrate, and the SOI substrate comprises one or more photonic components arranged therein or thereon.

10. A semiconductor optical amplifier comprising the waveguide structure of any preceding claim.

11. A laser comprising the waveguide structure of any preceding claim.

12. A photodiode comprising the waveguide structure of any preceding claim.

13. A modulator comprising the waveguide structure of any preceding claim.

14. A method of fabricating a waveguide structure, the method comprising:
providing a first waveguide (102), wherein the first waveguide is a semi-insulating buried heterostructure, SIBH, comprising a non-tapered section (150) and a tapered section (152), the tapered section connected to an end of the non-tapered section, and the non-tapered section and the tapered section being a III-V semiconductor material, the non-tapered section comprising two first sidewalls (106), wherein the two first sidewalls are substantially parallel to one another, and the tapered section comprising two second sidewalls (108), wherein the two second sidewalls are respectively connected to the first sidewalls and extend from the first sidewalls at an end of the non-tapered section toward one another to define a tapered shape;
depositing a dielectric layer (114) on the second sidewalls of the tapered section;
at least partially burying the non-tapered section and the tapered section in a thermally conductive cladding (112), wherein the dielectric layer is arranged between the second sidewalls and the thermally conductive cladding to separate the tapered section from the thermally conductive cladding; and
arranging the first waveguide on a second waveguide (110) so that an optical signal is transitionable from/to the first waveguide to/from the second waveguide, wherein the dielectric layer has a lower refractive index than the second waveguide.

15. The method of claim 14, wherein the method further comprises, before depositing the dielectric layer, depositing a second dielectric layer (205) on the second sidewalls of the tapered section, wherein the second dielectric layer is then arranged between the second sidewalls and the dielectric layer, and the second dielectric layer is configured to prevent III-V crystalline growth thereon.
